# EUROPÄISCHE PATENTSCHRIFT

(11) **EP 3 440 757 B1**
(45) Veröffentlichungstag und Bekanntmachung des Hinweises auf die Patenterteilung: **08.04.2020**
(21) Anmeldenummer: 17720503.6
(22) Anmeldetag: 02.05.2017
(51) Int. Cl.: H02J 3/38, H02J 13/00

(54) **ÜBERWACHEN DER INBETRIEBNAHME UND DER PLAUSIBILITÄT VON DATEN EINES LEISTUNGSMESSSENSORS IN EINEM VERTEILERNETZ**
MONITORING THE START-UP AND THE PLAUSIBILITY OF DATA OF A POWER MEASUREMENT SENSOR IN A DISTRIBUTER NETWORK
SURVEILLANCE DE LA MISE EN SERVICE ET DE LA PLAUSIBILITÉ DE DONNÉES D'UN CAPTEUR DE MESURE DE PUISSANCE DANS UN RÉSEAU DE DISTRIBUTION ÉLECTRIQUE

(30) Priorität: 10.05.2016 AT 504302016
(43) Veröffentlichungstag der Anmeldung: 13.02.2019
(73) Patentinhaber: Siemens AG Österreich, 1210 Wien (AT)
(72) Erfinder: EINFALT, Alfred, 1210 Wien (AT); LUGMAIER, Andreas, 1140 Wien (AT)
(74) Vertreter: Maier, Daniel Oliver
(86) Internationale Anmeldenummer: PCT/EP2017/060377
(87) Internationale Veröffentlichungsnummer: WO 2017/194349

(56) Entgegenhaltungen:
- WO-A1-2014/048664
- WO-A2-2012/055566
- JP-A- 2015 056 983

## Beschreibung

### Technisches Gebiet

Die Erfindung betrifft ein Verfahren zum Überwachen der Inbetriebnahme und der Plausibilität von Daten eines Leistungsmesssensors in einem Verteilernetz unter Verwendung einer Rechnereinheit,
welche über ein Topologiemodell des überwachten Verteilernetzes verfügt,
welche Rechnereinheit eine Kommunikationseinrichtung zur drahtlosen Kommunikation mit mobilen Endgeräten verfügt, welche Rechnereinheit neu in das Verteilernetz eingebaute Sensoren automatisch detektiert und in Datenaustausch mit dem neuen Sensor tritt.

Die Erfindung ist insbesondere auf Verteilernetze anwendbar, die als Niederspannungsnetze ausgebildet sind. Niederspannungsnetze sind ein Teil des Stromnetzes zur Verteilung der elektrischen Energie an den größten Teil der elektrischen Endverbraucher, der aus Niederspannungsgeräten besteht. Um Spannungsverluste zu vermeiden, sind Niederspannungsnetze in der räumlichen Ausdehnung auf einen Bereich von einigen 100 m bis zu einigen wenigen Kilometern beschränkt. Sie werden daher regional über Transformatorstationen (Ortsnetzstationen) aus einem übergeordneten Mittelspannungsnetz gespeist. Sie werden in Europa üblicher Weise mit einer Netzspannung von 230 V (zwischen jedem Außenleiter und dem Neutralleiter) bzw. 400 V (zwischen den drei Außenleitern), jedenfalls aber nur bis zu 1000 V betrieben. Bemessungsleistungen einzelner Ortsnetztransformatoren können je nach Zielnetzplanung des jeweiligen Verteilnetzbetreibers variieren, liegen aber typischer Weise bei 250 oder 400kVA für ländliche Gebiete und 630 oder 800kVA für innerstädtische Gebiete.

Der klassische Netzbetrieb wird durch die immer stärker werdende Durchdringung mit dezentralen, meist erneuerbaren Energieerzeugungsanlagen (DEA) als auch der zunehmenden Entwicklung der Elektromobilität vor große Herausforderungen gestellt. Dabei versteht man unter einer dezentralen Energieerzeugungsanlage (DEA) zum Beispiel eine Photovoltaikanlage oder eine Windkraftanlage.

### Stand der Technik

Als Lösung für die Probleme mit dezentralen Energieerzeugungsanlagen werden sogenannten "Smart Grids" angesehen, welche als intelligente Stromnetze die kommunikative Vernetzung und Steuerung von Stromerzeugern, Speichern, elektrischen Verbrauchern und Netzbetriebsmitteln in Energieübertragungs- und Energieverteilungsnetzen der Elektrizitätsversorgung umfassen.

Dabei kann die Netzstabilität in Energieübertragungs- und Energieverteilungsnetzen vorwiegend in zwei Problembereiche eingeteilt werden: Das vorherrschende Problem in ländlichen Energieverteilernetzen ist die Spannungshaltung, das auch als "U-Problem" bezeichnet wird. In urbanen Energieverteilernetzen, die aufgrund der Lastdichte eher geringe Leitungslängen aufweisen, ist weniger die Spannungshaltung als vielmehr das Problem der Auslastung von Betriebsmitteln vorherrschend. Dies wird auch als "I-Problem" bezeichnet. Dezentrale Einspeiser verringern dabei zunächst die hohe Auslastung von Leitungen und Transformatoren. In den seltensten Fällen werden aber auch die Leistungsgrenzen bei der Rückspeisung verletzt. Darüber hinaus können z.B. in suburbanen Gebieten Netzabschnitte innerhalb eines Netzgebietes sowohl einen ländlichen als auch einen urbanen Charakter haben. Um beim letzten Teilnehmer noch die durch Normen (beispielsweise durch die EN50160) vorgegebenen Spannungsgrenzen einzuhalten bzw. die Betriebsmittel nicht zu überlasten, muss entweder Netzausbau betrieben oder ein aktives Netzmanagementsystem eingesetzt werden. Letzteres greift gezielt auf Erzeuger, flexible Verbraucher oder auch Speicher im Energieverteilernetz zu, um den Netzbetrieb normgerecht aufrecht zu erhalten.

Für ein aktives Netzmanagementsystem ist der Einsatz von Sensoren im Verteilernetz notwendig. Mit den Daten dieser Sensoren können zum einen die Planungsaktivitäten des Verteilnetzbetreibers unterstützt werden, um einen gezielten Netzausbau zu ermöglichen, andererseits können die Sensoren auch zum Verteilen und Regeln der Energie eingesetzt werden.

Speziell für das I-Problem sind unter anderem Leistungsmesssensoren mit Stromwandlern und, im Falle von Niederspannungsnetzen, mit direktem Spannungsabgriff einzusetzen. In Kombination dieser beiden Messgrößen können auch der Phasenwinkel gemessen und nachgelagert Wirk- und Blindleistung berechnet werden. Anders als bei der Spannungsmessung ist hier die Richtung des Energieflusses durch den Stromwandler wesentlich. Der jeweilige Stromwandler muss korrekt eingebaut werden. Wird ein Stromwandler versehentlich falsch verdrahtet, so sind die Messwerte für die Leistung zwar in der gleichen Größenordnung, haben aber ein falsches Vorzeichen. Da zu erwarten ist, dass viele tausend Leistungsmesssensoren verbaut werden, ist mit solchen Fehlern zu rechnen.

Falls die Topologie des Verteilernetzes geändert wird, kann es ebenfalls zu einer Umkehr der Energieflussrichtung im Stromwandler kommen. Das Auswertungssystem der Leistungsmesssensoren muss dies durch einen entsprechenden Algorithmus abfangen, was bei vielen Leistungsmesssensoren mit hohem Aufwand verbunden ist.

Bisher wurden bei dezentralen Netzmanagementsystemen nur wenige Leistungsmesssensoren verwendet, welche durch Fachleute eingebaut und getestet wurden. Vor der Weiterleitung der Messdaten an eine nachgelagerte Netzplanungseinheit oder Betriebsführung des Verteilnetzbetreibers müssen die Messdaten kontrolliert und bei Topologieänderungen, welche eine Änderung der Energieflussrichtung für den betreffenden Leistungsmesssensor bewirken können, durch einen Algorithmus geändert werden, der auf Regeln basiert, in welchen Expertenwissen enthalten ist.

WO 2012/055566 A2 offenbart ein "Smart Grid" und ein darauf ablaufendes Verfahren nach dem einleitenden Teil von Anspruch 1.

### Darstellung der Erfindung

Eine Aufgabe der vorliegenden Erfindung ist es, ein Verfahren zur Verfügung zu stellen, mit welchem Fehler beim Einbau von Leistungsmesssensoren reduziert oder Auswirkungen von Änderungen der Topologie des Verteilnetzes bei den Leistungsmesssensoren berücksichtigt werden können.

Diese Aufgabe wird durch ein Verfahren mit den Merkmalen des Patentanspruchs 1 gelöst und umfasst ein Verfahren zum Überwachen der Inbetriebnahme und der Plausibilität von Daten eines Leistungsmesssensors in einem Verteilernetz unter Verwendung einer Rechnereinheit,
welche über ein Topologiemodell des überwachten Verteilernetzes verfügt,
welche Rechnereinheit eine Kommunikationseinrichtung zur drahtlosen Kommunikation mit mobilen Endgeräten verfügt, welche Rechnereinheit neu in das Verteilernetz eingebaute Sensoren automatisch detektiert und in Datenaustausch mit dem neuen Sensor tritt, welches Verfahren dadurch gekennzeichnet ist,
dass nach Detektieren eines in diesem Verteilernetz neuen Leistungsmesssensors durch die Rechnereinheit diese auf Basis von Messdaten bereits bestehender Leistungsmesssensoren in diesem Verteilernetz eine Überprüfung der Plausibilität der Messdaten des neuen Leistungsmesssensors durchführt, und dass durch die Rechnereinheit für den Fall nicht plausibler Messwerte des neuen Leistungsmesssensors eine Meldung zur manuellen Änderung des physischen Sensoranschlusses am Verteilernetz ausgegeben wird oder eine Korrektur der Daten des neuen Leistungsmesssensors oder eine Zuordnung des neuen Leistungsmesssensors zu einem anderen Verteilernetz erfolgt.

Das Topologiemodell umfasst zumindest Informationen über den Verlauf der einzelnen Zweige des Verteilernetzes, insbesondere eines Niederspannungsnetzes (z.B. Sternform, Ringform), sowie über dessen Knotenpunkte, an denen eine Verzweigung des Verteilernetzes erfolgt oder ein Energieverbraucher (z.B. ein Gebäude) oder ein Energielieferant (z.B. ein dezentrales Einspeiser) angeschlossen ist. Insbesondere enthält das Topologiemodell die relative Lage der einzelnen Knotenpunkte zueinander, also etwa die Reihenfolge der Knotenpunkte, Leistungsmesssensoren, Verzweigungen, etc.

Dass die Rechnereinheit über eine Kommunikationseinrichtung zur drahtlosen Kommunikation mit mobilen Endgeräten verfügt, hat den Zweck, dass die Rechnereinheit mit einem Monteur eines Leistungsmesssensors interagieren kann.

Die Rechnereinheit kann neu in das Verteilernetz, insbesondere das Niederspannungsnetz eingebaute Sensoren automatisch detektieren und in Datenaustausch mit dem neuen Sensor treten. Diese Funktion besteht etwa bereits im Zusammenhang mit sogenannten Smart Metern (intelligenten Stromzählern), dies ebenfalls mittels Plug&Play-Funktion installiert werden, die sich also ebenfalls nach Montage im Rahmen einer automatisierten Anmeldeprozedur bei einer zentralen Rechnereinheit anmelden, von dieser als Smart Meter erkannt werden und in Hinkunft die Daten dieses Smart Meters entsprechend gespeichert werden, entweder lokal in der Rechnereinheit oder in einem anderen Speicher, auf den die Rechnereinheit Zugriff hat.

Die Rechnereinheit verfügt auch über Messdaten von bereits bestehenden Leistungsmesssensoren. Diese Messdaten können entweder wieder lokal in der Rechnereinheit hinterlegt sein, der Speicher für diese Messdaten könnte jedoch der Rechnereinheit auch drahtgebunden oder drahtlos von einem anderen Ort aus zur Verfügung gestellt werden. Der Speicher für die Messdaten der Leistungsmesssensoren legt sowohl synchron als auch asynchron eintreffende Messdaten vorzugsweise als unbeschränkte Zeitreihen ab. Dadurch können diese von der Rechnereinheit selbst als auch von übergeordneten Steuereinheiten insbesondere in Abhängigkeit von der Zeit abgefragt werden.

Die erfindungsgemäße Rechnereinheit kann als intelligente Rechnereinheit bezeichnet werden, da sie so viel Wissen über ihre Umgebung und die Gesetzmäßigkeiten darin hat, um mit den Leistungsmesssensoren des Verteilernetzes einen Fehlerfall zu klären. Die Rechnereinheit kann im Falle eines Niederspannungsnetzes Teil einer intelligenten Ortsnetzstation (iONS) sein.

Falls die Leistungsmesssensoren bereits über eine sogenannte Power Line Communication (PLC) mit einem Datenkonzentrator mit integrierter oder externer intelligenter Rechnereinheit kommunizieren können, besteht bereits die Möglichkeit, eine exakte Phasenzuordnung der einzelnen Messungen eines Leistungsmesssensors auf einen Referenzpunkt anzugeben, meist auf den Transformatorabgang der Ortsnetzstation.

Falls die Leistungsmesssensoren keine Power Line Communication (PLC) verwenden und auch keine andere Kommunikationsmethode, die eine Phasenzuordnung ermöglicht, kann im Zuge der Plausibilitätsprüfung in der Rechnereinheit in bestimmten Grenzen auch die Phasenzuordnung erfolgen.

In ersten Fall der Erfindung, der Meldung zur manuellen Änderung des physischen Sensoranschlusses am Verteilernetz, kann vorgesehen sein, dass eine drahtlose Kommunikationsverbindung zwischen der Rechnereinheit und einem mobilen Endgerät eines Monteurs des neuen Leistungsmesssensors aufgebaut wird und Messdaten des neuen Leistungsmesssensors oder daraus abgeleitete Informationen an das mobile Endgerät des Monteurs gesendet werden.

Der Monteur baut den neuen Leistungsmesssensor nach einem vorgegebenen Plan ein. Nach dem Verbinden der Spannungsmessklemmen beginnt die Plug&Play Anmeldeprozedur durch den Leistungsmesssensor bei der Rechnereinheit. Die Rechnereinheit führt die Anmeldung durch und beginnt mit der Plausibilitätsprüfung der vom neuen Leistungsmesssensor empfangenen Messdaten. Dazu benötigt die Rechnereinheit die Messdaten zumindest eines vorhandenen Leistungsmesssensors - in der Regel ist ein Referenzsensor in der Ortsnetzstation vorhanden. Mit jedem weiteren Leistungsmesssensor steigt die Zuverlässigkeit der Plausibilitätsprüfung.

Nun ist es wesentlich, dass der Monteur über ein mobiles Endgerät zur Datenübertragung verfügt, wie z.B. ein Mobiltelefon (Smart Phone), einen Tablet-Computer oder Ähnliches. Mit diesem Endgerät kann eine Verbindung zur Rechnereinheit hergestellt werden, sodass die Rechnereinheit erste Informationen über den neuen Leistungsmesssensor, den der Monteur gerade eingebaut hat, an das Endgerät senden kann. Diese Informationen können z.B. enthalten, dass der neue Leistungsmesssensor ordnungsgemäß angemeldet worden ist und die Phasenzuordnung bzw. Drehfeldrichtung der angeschlossenen Spannungsmessklemmen stimmt. Sobald auch nach und nach Messwerte der bereits vorhandenen Leistungsmesssensoren bei der Rechnereinheit eintreffen, werden auch hierzu Informationen übertragen. Ergibt die Plausibilitätsprüfung, dass die Messwerte des neuen Leistungsmesssensors nicht in Ordnung sind, kann der Monteur auf diesen Zustand hingewiesen und z.B. aufgefordert werden, die Anschlüsse nochmals zu überprüfen. Ist keine Plausibilitätsprüfung möglich, weil nicht genügend Messdaten von anderen Leistungsmesssensoren vorhanden sind, so können dem Monteur am Endgerät Messwerte und Ort eines anderen Leistungsmesssensors gesendet werden, um es dem Monteur zu ermöglichen, selbst einen Fehler zu erkennen.

Im zweiten Fall der Erfindung, der Korrektur der Daten des neuen Leistungsmesssensors, kann vorgesehen sein, dass eine Korrektur der Messwerte des neuen Leistungsmesssensors durch eine Änderung des Phasenwinkels bzw. des Vorzeichens des Leistungsmesswerts erfolgt. Zusätzlich oder alternativ kann im zweiten Fall vorgesehen sein, dass bei einer Korrektur der Daten des neuen Leistungsmesssensors eine Korrektur der Phasenzuordnung des neuen Leistungsmesssensors erfolgt.

Wenn beispielsweise der Rechnereinheit noch zu wenige Messdaten zur Verfügung stehen während der Monteur des neuen Leistungsmesssensors noch vor Ort ist, sodass dem Monteur keine Informationen über notwendige Änderungen gegeben werden können, kann die Rechnereinheit als Zusatzfunktion mittels Software eine Korrektur eines z.B. falsch eingebauten Leistungsmesssensors durchführen. Dazu muss im Prinzip z.B. nur das Vorzeichen des Leistungsmesswerts geändert werden. Auch eine Korrektur der Phasenzuordnung des neuen Leistungsmesssensors ist über die Software der Rechnereinheit möglich. Da die erfindungsgemäße Rechnereinheit die unterste Ebene der Hierarchie der Messdatennutzung darstellt, ist es wichtig, dass eine etwaige Korrektur der Messwerte auch dezentral durch die Rechnereinheit durchgeführt wird. Dadurch müssen nachfolgende Systeme, die meist durch menschliches Engineering hergestellt werden, nicht alle mühsam geändert werden.

Im dritten Fall der Erfindung, der Zuordnung des neuen Leistungsmesssensors zu einem anderen Verteilernetz, insbesondere einem anderen Niederspannungsnetz, kann vorgesehen sein, dass die Rechnereinheit eine Kommunikationsverbindung mit einer weiteren Rechnereinheit eines weiteren Verteilernetzes aufbaut und die Ergebnisse der Überprüfung der Plausibilität der beiden Rechnereinheiten verglichen werden.

Die erfindungsgemäße Plausibilitätsprüfung kann also nicht nur für den Fall angewendet werden, dass ein Leistungsmesssensor physisch erstmals in das Verteilernetz der Rechnereinheit eingebaut wird, sondern auch für den Fall, dass ein bestehender Leistungsmesssensor aufgrund von Änderungen der Netztopologie als neu eingebauter Leistungsmesssensor interpretiert wird. So ist etwa bei der Power Line Communication ein Übersprechen von einem Niederspannungsnetz auf ein anderes Niederspannungsnetz bekannt. Hier kann die Plausibilitätsprüfung des vermeintlich neuen Leistungsmesssensors ergeben, dass dieser sich gar nicht im gegenständlichen Niederspannungsnetz befindet.

Eine Weiterbildung der gegenständlichen Erfindung kann dann entsprechend vorsehen, dass die Rechnereinheit des einen Niederspannungsnetzes mit der - ebenfalls erfindungsgemäß ausgebildeten - Rechnereinheit eines anderen Niederspannungsnetzes in Kontakt tritt, beide Rechnereinheiten ihre Plausibilitätsüberprüfungen zu diesem Leistungsmesssensor vergleichen und anschließend eine Neuzuordnung des Leistungsmesssensors - hier ins andere Niederspannungsnetz - erfolgt.

Durch eine geänderte Zuordnung neu in ein Niederspannungsnetz hinzugekommene Leistungsmesssensoren werden wie gewohnt angemeldet und einer Prüfung unterzogen. Der Stromwandler dieses Leistungsmesssensors kann nach eine topologischen Umschaltung nun generell eine zu den anderen Leistungsmesssensoren abweichende Normaldurchflussrichtung aufweisen. Auch in diesem Fall kann eine Korrektur der Durchflussrichtung durch die Software der Rechnereinheit erfolgen, um möglichst dezentral eine Richtigstellung durchzuführen.

Erfolgt die Topologieänderung durch eine manuelle Schaltung eines Monteurs, so kann dieser vor Ort beim Leistungsmesssensor durch Kommunikation mit der Rechnereinheit über sein mobiles Endgerät Informationen über den Leistungsmesssensor einholen oder auf Fehler hingewiesen werden.

Die Plausibilitätsprüfung, auch Plausibilitätskontrolle oder Plausibilisierung, ist eine Methode, in deren Rahmen ein Wert oder allgemein ein Ergebnis überschlagsmäßig daraufhin überprüft wird, ob es überhaupt plausibel, also annehmbar, einleuchtend und nachvollziehbar sein kann oder nicht. Es kann nicht immer die Richtigkeit des Wertes oder Ergebnisses verifiziert werden, sondern es soll eine gegebenenfalls vorhandene offensichtliche Unrichtigkeit erkannt werden. Ein Vorteil der Plausibilitätskontrolle ist, dass sie mit lediglich geringem Aufwand durchgeführt werden kann, ein Nachteil ist, dass weniger offensichtliche Unrichtigkeiten in ihrem Rahmen nicht erkannt werden.

Die Überprüfung der Plausibilität kann durch an sich bekannte mathematische Verfahren erfolgen, etwa aus der Statistik. Dabei kann sich die Rechnereinheit mehrerer unterschiedlicher Verfahren bedienen bzw. können auch immer wieder neue Verfahren mit aufgenommen werden. Je nach Anzahl der bereits installierten Leistungsmesssensoren und der entsprechenden Datenbasis reichen auch einfache Verfahren aus, um ein schnelles Ergebnis zur erhalten.

So kann vorgesehen sein, dass die Überprüfung der Plausibilität durch mathematische Kombinationsverfahren erfolgt, die auf Messwerte verschiedener Leistungsmesssensoren des Verteilernetzes angewendet werden. So könnte z.B. die Summe der Messwerte einer ersten Untermenge aller Leistungsmesssensoren berechnet werden, dann die Summe einer zweiten Untermenge, also einer anderen Kombination von Leistungsmesssensoren, und so weiter. Dieses Verfahren ist besonders einfach und kann verwendet werden, wenn schon eine Anzahl Leistungsmesssensoren vorhanden ist, die dem neuen Leistungsmesssensor nachgelagert oder vorgelagert sind. Auf diese Weise kann einfach ein falsch eingebauter Stromwandler des neuen Leistungsmesssensors erkannt werden.

Eine andere Gruppe von Verfahren sieht vor, dass die Überprüfung der Plausibilität durch mathematische Merkmalverfahren erfolgt, die auf Extremwerten oder Steigungen von Messwerten von Leistungsmesssensoren des Niederspannungsnetzes beruhen.

Bei den Merkmalverfahren auf Basis von Extremwerten werden z.B. alle Messwerte der Leistungsmesssensoren über einer bestimmten Schwelle im zeitlichen Verlauf als Kanten detektiert. Die Ergebnisse der Kantenauswertungen der einzelnen Leistungsmesssensoren werden verglichen. Deren normierter Abstand bzw. der Phasenvergleich bzw. der Vorzeichenvergleich kann Auskunft über die korrekte Durchflussrichtung, Phasenzuordnung und sogar über den Einbauort geben.

Bei Merkmalverfahren auf Basis von Steigungen werden die Steigungen der zeitlichen Verläufe der Messwerte für die verschiedenen Leistungsmesssensoren abschnittsweise linearisiert und die erste Ableitung gebildet. Die Werte der ersten Ableitung verschiedener Leistungsmesssensoren werden dann untereinander verglichen. Je nach Dynamik der Messwerte bzw. dem Vorhandensein von Extremwerten kann die Methode mit den Extremwerten oder die Methode mit den Steigungen bessere Ergebnisse bringen.

Wenn ein Merkmalverfahren auf die Messwertreihen einzelner Phasenmessungen von Strom und Spannung bei ausreichender Anzahl von Leistungsmesssensoren angewendet wird, kann damit eine konsistente Phasenzuordnung eines neuen Leistungsmesssensors erfolgen.

Wenn Messwerte des Stroms von mehreren Leistungsmesssensoren über einen längeren Zeitraum vorliegen, ist es vorteilhaft, wenn die Überprüfung der Plausibilität durch schnelle Fourier-Transformation von Strommesswerten von Leistungsmesssensoren des Niederspannungsnetzes und Vergleich des niederfrequenten Spektrums der Messwertreihen erfolgt. Der Stromverlauf über die Zeit wird also für jeden Leistungsmesssensor vom Zeitraum in den Frequenzraum transformiert und die Spektren der unterschiedlichen Leistungsmesssensoren werden dann untereinander verglichen.

Aus dem Bereich der Prognosen kann ein Ansatz übernommen werden, wonach unterschiedliche Methoden der Plausibilitätsprüfung entsprechend einer selbstlernenden Fuzzy Methode bewertet werden und je nach Anwendungsfall (z.B. abhängig von der Anzahl der bekannten Leistungsmesssensoren) möglichst rasch eine Ergebnis durch Auswahl eines Verfahrens oder durch Einsatz mehrerer Verfahren und anschließender Gewichtung der unterschiedlichen Ergebnisse erreicht wird. Insofern kann vorgesehen sein, dass mehrere unterschiedlichen Verfahren zur Überprüfung der Plausibilität angewendet und mittels selbstlernender Algorithmen ausgewertet werden.

Das erfindungsgemäße Verfahren wird in der Regel rechnergestützt durchgeführt werden. Entsprechend kann die gegenständliche Erfindung auch als Computerprogrammprodukt realisiert werden, welches ein Programm umfasst und direkt in einen Speicher einer Rechnereinheit eines Verteilernetzes ladbar ist, mit Programm-Mitteln, um alle Schritte des erfindungsgemäßen Verfahrens auszuführen, wenn das Programm von der Rechnereinheit ausgeführt wird.

Der Einsatz des erfindungsgemäßen Überwachungsverfahrens dienst als Basis aller nachfolgenden Smart Grid Anwendungen und Planungsprozesse des Niederspannungsnetzes, das Verfahren kann grundsätzlich auch für Mittelspannungsnetze angewendet werden. Da der Einbau einer großen Anzahl von Leistungsmesssensoren viele Fehlerquellen birgt, können etwaige Fehler mit dem erfindungsgemäßen Verfahren reduziert und eine hohe Qualität der Leistungs- bzw. Strommesswerte sichergestellt werden. Von der Qualität der Messwerte hängt der Erfolg der nachfolgenden Smart Grid Anwendungen ab.

Mit dem erfindungsgemäßen Verfahren ist eine dezentrale, laufende und vollautomatische Plausibilitätsüberprüfung möglich. Der Monteur eines neuen Leistungsmesssensors erhält unmittelbar vor Ort eine Rückmeldung und eine Kontrollmöglichkeit. Dadurch kann die Einsatzzeit von Monteuren optimiert werden, da keine weiteren Anfahrten aufgrund sonst später gefundener Fehler notwendig sind. Falls ein Fehler doch nicht gleich erkannt wird, werden diese immer noch dezentral von der Rechnereinheit erkannt und durch Eingriff über die Software der Rechnereinheit korrigiert. Es ist dann also kein nachgelagertes menschliches Bearbeiten in der Leittechnik des Energieversorgers oder im geografischen Informationssystem (GIS-System) erforderlich.

Mit den installierten Leistungsmesssensoren könnte im Hinblick auf die gewünschte Automatisierung von Niederspannungsnetzen auch eine Zusatzfunktionalität bereitgestellt werden, indem bereits bei Überlastung eines Netzabschnitts eine Meldung an eine übergeordnete Regelungsinstanz des Niederspannungsnetzes erfolgt. Damit kann dem eingangs erwähnten I-Problem Rechnung getragen werden, also eine Überlastung erkannt (und dieser gegebenenfalls entgegengewirkt) werden, bevor ein Fehlerfall entsteht.

### Kurzbeschreibung der Figuren

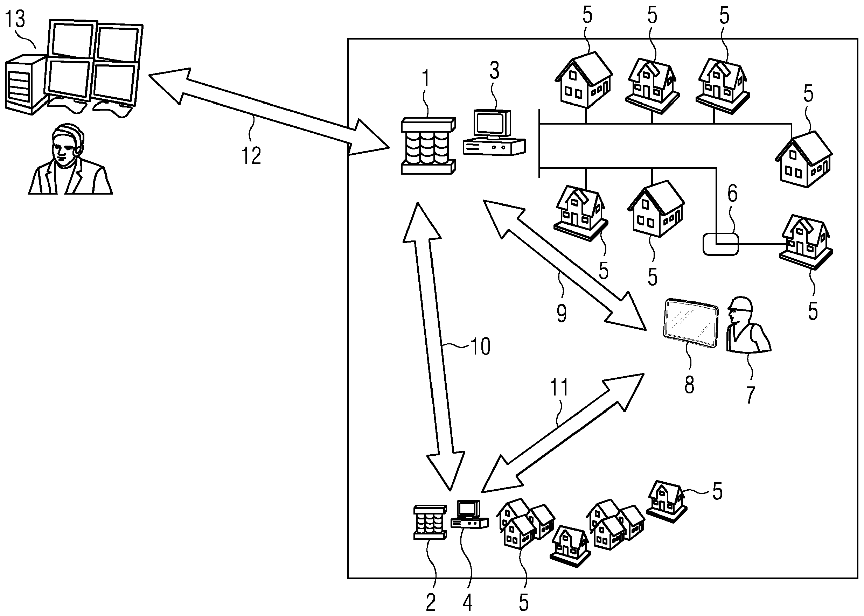

Zur weiteren Erläuterung der Erfindung wird im nachfolgenden Teil der Beschreibung auf die Figur Bezug genommen, aus der weitere vorteilhafte Ausgestaltungen, Einzelheiten und Weiterbildungen der Erfindung zu entnehmen sind. Dabei zeigt die Figur eine schematische Darstellung eines Niederspannungsnetzes.

### Ausführung der Erfindung

Die Fig. zeigt ein Niederspannungsnetz, z.B. ein Ortsnetz, welches von einer ersten Ortsnetzstation 1 ausgeht, die durch einen Transformator repräsentiert wird. Dabei sind die elektrischen Leitungen des Niederspannungsnetzes als dicke durchgezogene Linien dargestellt. Das Niederspannungsnetz hat hier zwei Zweige mit jeweils mehreren Netzknoten, nämlich Abzweige zu einzelnen Gebäuden 5. Im unteren Zweig wird zwischen dem zweiten und dem dritten Netzknoten ein neuer Leistungsmesssensor 6 eingebaut, und zwar durch den Monteur 7, der ein mobiles Endgerät 8 zur Verfügung hat. Dieses mobile Endgerät 8 ist während der Montage über eine drahtlose Kommunikationsverbindung 9 mit der erfindungsgemäßen Rechnereinheit 3 der Ortsnetzstation 1 verbunden.

Die Rechnereinheit 3 weist die folgenden Softwaremodule auf: ein Kommunikationsmodul zur Kommunikation mit den Leistungsmesssensoren 6, also zur Übertragung von Messwerten und zum Durchführen der Anmeldeprozedur mittels Plug&Play; ein Kommunikationsmodul zur drahtlosen Kommunikation mit dem beim Leistungsmesssensor 6 befindlichen Monteur 7;
ein Kommunikationsmodul zur Kommunikation mit der Ortsnetzstation 1 (eines sogenannten Secondary Substation Nodes);
ein Kommunikationsmodul zur übergeordneten Verwaltung des Energieverteilnetzes, dem Verteilnetzbetreiber (SCDA);
ein Speichermodul zur Speicherung von Zeitreihen der Messwerte der einzelnen Leistungsmesssensoren 6 und zur Speicherung von Topologiedaten des Niederspannungsnetzes;
ein Modul zur Plausibilitätsprüfung;
ein Modul zur Durchführung und Verwaltung dezentraler Korrekturen, wie der Richtung des Stromdurchflusses durch die einzelnen Leistungsmesssensoren 6;
optional ein oder mehrere weitere Software-Module zur dezentralen Regelung des Niederspannungsnetzes.

Sobald der Leistungsmesssensor 6 vom Monteur 7 angeschlossen worden ist, meldet sich der Leistungsmesssensor 6 über PLC bei der Rechnereinheit 3 an und sendet Messdaten. Auf Basis dieser Messdaten und auf Basis von Messdaten bereits bestehender Leistungsmesssensoren in diesem Niederspannungsnetz, die hier nicht eingezeichnet sind, erfolgt die Plausibilitätsprüfung durch die Rechnereinheit 3. Sind die Messwerte des Leistungsmesssensors 6 plausibel, so könnte von der Rechnereinheit 3 über die drahtlose Kommunikationsverbindung 9 eine Meldung an das Endgerät 8 abgesetzt werden, dass der Leistungsmesssensor 6 richtig installiert worden ist. Sind die Messwerte des Leistungsmesssensors 6 nicht plausibel, so wird die Rechnereinheit 3 den Monteur über das Endgerät 8 auffordern, die Anschlüsse des Leistungsmesssensors 6 zu überprüfen. Liegt noch kein Ergebnis der Plausibilitätsprüfung vor, so können dem Monteur 7 über die drahtlose Kommunikationsverbindung 9 auch Messwerte des Leistungsmesssensors 6 und anderer Leistungsmesssensoren dieses Niederspannungsnetzes übermittelt werden. Aus diesen Messwerten kann der Monteur 7 möglicher Weise selbst das Problem erkennen.

Kann der Fehler durch den Monteur 7 nicht behoben werden oder ist der Monteur 7 nicht mehr vor Ort, kann eine Korrektur der Daten des neuen Leistungsmesssensors 6, wenn es etwa nur um die Durchflussrichtung geht, durch Änderung des Vorzeichens der Stromwerte durch die Rechnereinheit 3 selbst behoben werden.

In der Figur ist auch ein zweites Niederspannungsnetz eingezeichnet, das beispielhaft aus mehreren Gebäuden 5 besteht, die von einer zweiten Ortsnetzstation 2 versorgt werden. Die zweite Ortsnetzstation 2 verfügt über eine weitere intelligente Rechnereinheit 4. Die zweite Ortsnetzstation 2 ist mit der ersten Ortsnetzstation 1 über eine Kommunikationsverbindung 10 verbunden, über welche im Zuge von Umschaltungen (also Topologieänderungen) oder Sensorzuordnungen etwa die Ergebnisse von Plausibilitätsüberprüfungen ausgetauscht werden können.

Erfolgt durch den Monteur 7 eine Änderung der Topologie des Niederspannungsnetzes durch eine manuelle Schaltung, wird also z.B. ein Zweig des Niederspannungsnetzes der Ortsnetzstation 1 dem Niederspannungsnetz der Ortsnetzstation 2 zugeordnet, so kann der Monteur 7 vor Ort über sein Endgerät 8 notwendige Informationen von den entsprechenden Rechnereinheiten 3,4 einholen oder von diesen auf mögliche Probleme hingewiesen werden. Dazu kann die Rechnereinheit 4 eine drahtlose Kommunikationsverbindung 11 mit dem Endgerät 8 aufbauen. Gehört der Leistungsmesssensor 6 nun zum Niederspannungsnetz der zweiten Ortsnetzstation 2 und stellt die Rechnereinheit 4 fest, dass die Durchflussrichtung des Stroms falsch ist, könnte der Monteur 7 die Anschlüsse des Leistungsmesssensors 6 gleich entsprechend ändern.

Nur für die Ortsnetzstation 1 ist eine Kommunikationsverbindung 12 zur übergeordneten Verwaltung 13 des Energieverteilnetzes, dem Verteilnetzbetreiber, eingezeichnet. Über diese Kommunikationsverbindung 12 werden überprüfte und gegebenenfalls korrigierte Messwerte, wie z.B. Strommesswerte der Leistungsmesssensoren 6, von der Rechnereinheit 3 zur übergeordneten Verwaltung 13 des Energieverteilnetzes gesendet. Die Verwaltung 13 gehört nicht mehr zur Ebene der Niederspannungsnetze, welche Ebene durch die schwarze Umrandung gekennzeichnet ist.

### Bezugszeichenliste:

- 1: erste Ortsnetzstation
- 2: zweite Ortsnetzstation
- 3: Rechnereinheit der ersten Ortsnetzstation 1
- 4: weitere Rechnereinheit der zweiten Ortsnetzstation 2
- 5: Gebäude
- 6: Leistungsmesssensor
- 7: Monteur
- 8: mobiles Endgerät
- 9: drahtlose Kommunikationsverbindung
- 10: Kommunikationsverbindung zwischen Ortsnetzstationen 1,2
- 11: drahtlose Kommunikationsverbindung
- 12: Kommunikationsverbindung zwischen 1 und 13
- 13: Verwaltung 13 des Energieverteilnetzes

## Patentansprüche

1. Verfahren zum Überwachen der Inbetriebnahme und der Plausibilität von Daten eines Leistungsmesssensors (6) in einem Verteilernetz unter Verwendung einer Rechnereinheit (3,4),
welche über ein Topologiemodell des überwachten Verteilernetzes verfügt,
welche Rechnereinheit (3,4) eine Kommunikationseinrichtung zur drahtlosen Kommunikation mit mobilen Endgeräten (8) verfügt,
welche Rechnereinheit (3,4) neu in das Verteilernetz eingebaute Sensoren automatisch detektiert und in Datenaustausch mit dem neuen Sensor tritt, **dadurch gekennzeichnet,**
**dass** nach Detektieren eines in diesem Verteilernetz neuen Leistungsmesssensors (6) durch die Rechnereinheit (3,4) diese auf Basis von Messdaten bereits bestehender Leistungsmesssensoren in diesem Verteilernetz eine Überprüfung der Plausibilität der Messdaten des neuen Leistungsmesssensors (6) durchführt,
**dass** durch die Rechnereinheit (3,4) für den Fall nicht plausibler Messwerte des neuen Leistungsmesssensors (6) eine Meldung zur manuellen Änderung des physischen Sensoranschlusses am Verteilernetz ausgegeben wird oder eine Korrektur der Daten des neuen Leistungsmesssensors (6) oder eine Zuordnung des neuen Leistungsmesssensors (6) zu einem anderen Verteilernetz erfolgt, und dass vor einer Zuordnung des neuen Leistungsmesssensors (6) zu einem anderen Verteilernetz die Rechnereinheit (3,4) eine Kommunikationsverbindung (10) mit einer weiteren Rechnereinheit (4) eines weiteren Verteilernetzes aufbaut und die Ergebnisse der Überprüfung der Plausibilität der beiden Rechnereinheiten (3,4) verglichen werden.

2. Verfahren nach Anspruch 1, **dadurch gekennzeichnet, dass** eine drahtlose Kommunikationsverbindung (9,11) zwischen der Rechnereinheit (3,4) und einem mobilen Endgerät (8) eines Monteurs (7) des neuen Leistungsmesssensors (6) aufgebaut wird und Messdaten des neuen Leistungsmesssensors (6) oder daraus abgeleitete Informationen an das mobile Endgerät (8) des Monteurs (7) gesendet werden.

3. Verfahren nach Anspruch 1 oder 2, **dadurch gekennzeichnet, dass** bei einer Korrektur der Daten des neuen Leistungsmesssensors (6) eine Korrektur der Messwerte des neuen Leistungsmesssensors durch eine Änderung des Phasenwinkels bzw. des Vorzeichens des Leistungsmesswerts erfolgt.

4. Verfahren nach einem der vorhergehenden Ansprüche, **dadurch gekennzeichnet, dass** bei einer Korrektur der Daten des neuen Leistungsmesssensors (6) eine Korrektur der Phasenzuordnung des neuen Leistungsmesssensors (6) erfolgt.

5. Verfahren nach einem der vorhergehenden Ansprüche, **dadurch gekennzeichnet, dass** die Überprüfung der Plausibilität durch mathematische Kombinationsverfahren erfolgt, die auf Messwerte verschiedener Leistungsmesssensoren (6) des Verteilernetzes angewendet werden.

6. Verfahren nach einem der vorhergehenden Ansprüche, **dadurch gekennzeichnet, dass** die Überprüfung der Plausibilität durch mathematische Merkmalverfahren erfolgt, die auf Extremwerten oder Steigungen von Messwerten von Leistungsmesssensoren (6) des Verteilernetzes beruhen.

7. Verfahren nach einem der vorhergehenden Ansprüche, **dadurch gekennzeichnet, dass** die Überprüfung der Plausibilität durch schnelle Fourier-Transformation von Strommesswerten von Leistungsmesssensoren (6) des Verteilernetzes und Vergleich des niederfrequenten Spektrums der Messwertreihen erfolgt.

8. Verfahren nach einem der vorhergehenden Ansprüche, **dadurch gekennzeichnet, dass** mehrere unterschiedlichen Verfahren zur Überprüfung der Plausibilität angewendet und mittels selbstlernender Algorithmen ausgewertet werden.

9. Verfahren nach einem der vorhergehenden Ansprüche, **dadurch gekennzeichnet, dass** das Verteilernetz oder gegebenenfalls das weitere Verteilernetz jeweils ein Niederspannungsnetz ist.

10. Verfahren nach einem der vorhergehenden Ansprüche, **dadurch gekennzeichnet, dass** der Leistungsmesssensor (6) einen Stromwandler umfasst.

11. Verfahren Anspruch 9 und 10, **dadurch gekennzeichnet, dass** der Leistungsmesssensor (6) zusätzlich einen direkten Spannungsabgriff für das Niederspannungsnetz aufweist.

12. Computerprogrammprodukt, welches ein Programm umfasst und direkt in einen Speicher einer Rechnereinheit (3,4) eines Verteilernetzes ladbar ist, mit Programm-Mitteln, um alle Schritte des Verfahrens nach einem der Ansprüche 1 bis 12 auszuführen, wenn das Programm von der Rechnereinheit (3,4) ausgeführt wird.

## Claims

1. Method for monitoring the start-up and the plausibility of data of a power measurement sensor (6) in a distributer network using a computer unit (3, 4) which has a topology model of the monitored distributer network,
which computer unit (3, 4) has a communication device for wireless communication with mobile terminals (8),
which computer unit (3, 4) automatically detects new sensors installed in the distributer network and enters into an exchange of data with the new sensor, **characterised in that**
after the detection of a new power measurement sensor (6) in this distributer network by the computer unit (3, 4), said computer unit (3, 4) carries out a check on the plausibility of the measured data of the new power measurement sensor (6) on the basis of measured data of existing power measurement sensors in this distributer network,
that in the event of non-plausible measured values of the new power measurement sensor (6) a message to manually change the physical sensor connection on the distributer network is output by the computer unit (3, 4) or a correction of the data of the new power measurement sensor (6) or an assignment of the new power measurement sensor (6) to another distributer network takes place, and that before the new power measurement sensor (6) is assigned to another distributer network, the computer unit (3, 4) establishes a communication link (10) to a further computer unit (4) of a further distributer network and the results of checking the plausibility of the two computer units (3, 4) are compared.

2. Method according to claim 1, **characterised in that** a wireless communication link (9, 11) is set up between the computer unit (3, 4) and a mobile terminal (8) of a fitter (7) of the new power measurement sensor (6) and measured data of the new power measurement sensor (6) or information derived therefrom is sent to the mobile terminal (8) of the fitter (7).

3. Method according to claim 1 or 2, **characterised in that** when the data of the new power measurement sensor (6) is corrected, a correction of the measured values of the new power measurement sensor takes place by changing the phase angle or the sign of the power measurement value.

4. Method according to one of the preceding claims, **characterised in that** when the data of the new power measurement sensor (6) is corrected, a correction of the phase assignment of the new power measurement sensor (6) takes place.

5. Method according to one of the preceding claims, **characterised in that** the plausibility is checked by mathematical combination methods which are applied to measured values of various power measurement sensors (6) of the distributer network.

6. Method according to one of the preceding claims, **characterised in that** the plausibility is checked by mathematical feature methods which are based on extreme values or gradients of measured values from power measurement sensors (6) of the distributer network.

7. Method according to one of the preceding claims, **characterised in that** the plausibility is checked by rapid Fourier transformation of current measured values from power measurement sensors (6) of the distributer network and comparison of the low-frequency spectrum of the measured value series.

8. Method according to one of the preceding claims, **characterised in that** several different methods are used to check the plausibility and are evaluated by means of self-learning algorithms.

9. Method according to one of the preceding claims, **characterised in that** the distributer network or where appropriate the further distributer network is in each case a low-voltage network.

10. Method according to one of the preceding claims, **characterised in that** the power measurement sensor (6) comprises a current transformer.

11. Method according to claim 9 and 10, **characterised in that** the power measurement sensor (6) additionally has a direct voltage tap for the low-voltage network.

12. Computer program product, which comprises a program and can be loaded directly into a memory of a computer unit (3, 4) of a distributer network, having program means to carry out all steps of the method according to one of claims 1 to 12 when the program is executed by the computer unit (3, 4).

## Revendications

1. Procédé de surveillance de la mise en service et de la plausibilité de données d'un capteur de mesure de puissance (6) dans un réseau de distribution moyennant l'utilisation d'une unité de calcul (3,4) qui dispose d'un modèle de topologie du réseau de distribution surveillé, laquelle unité de calcul (3,4) dispose d'un dispositif de communication pour la communication sans fil avec des terminaux mobiles (8), laquelle unité de calcul (3,4) détecte automatiquement des capteurs nouvellement intégrés au réseau de distribution et engage un échange de données avec le nouveau capteur, **caractérisé en ce que**, après la détection, par l'unité de calcul (3, 4), d'un capteur de mesure de puissance (6) nouveau dans ce réseau de distribution, celle-ci effectue, sur la base de données de mesure de capteurs de mesure de puissance déjà existants dans ce réseau de distribution, une vérification de la plausibilité des données de mesure du nouveau capteur de mesure de puissance (6), **en ce que** l'unité de calcul (3,4) émet, dans le cas de valeurs de mesure non plausibles du nouveau capteur de mesure de puissance (6), un message pour la modification manuelle du raccordement physique du capteur au réseau de distribution ou une correction des données du nouveau capteur de mesure de puissance (6) ou une affectation du nouveau capteur de mesure de puissance (6) à un autre réseau de distribution est effectuée, et **en ce que**, avant une affectation du nouveau capteur de mesure de puissance (6) à un autre réseau de distribution, l'unité de calcul (3,4) établit une liaison de communication (10) avec une autre unité de calcul (4) d'un autre réseau de distribution et les résultats de la vérification de la plausibilité des deux unités de calcul (3,4) sont comparés.

2. Procédé selon la revendication 1, **caractérisé en ce qu'**une liaison de communication sans fil (9,11) est établie entre l'unité de calcul (3,4) et un terminal mobile (8) d'un monteur (7) du nouveau capteur de mesure de puissance (6) et des données de mesure du nouveau capteur de mesure de puissance (6) ou des informations qui en sont dérivées sont envoyées au terminal mobile (8) du monteur (7).

3. Procédé selon la revendication 1 ou 2, **caractérisé en ce que**, en cas de correction des données du nouveau capteur de mesure de puissance (6), une correction des valeurs de mesure du nouveau capteur de mesure de puissance est opérée par une modification de l'angle de phase resp. du signe algébrique de la valeur de mesure de puissance.

4. Procédé selon l'une des revendications précédentes, **caractérisé en ce qu'**est effectuée, en cas de correction des données du nouveau capteur de mesure de puissance (6), une correction de l'affectation de phase du nouveau capteur de mesure de puissance (6).

5. Procédé selon l'une des revendications précédentes, **caractérisé en ce que** la vérification de la plausibilité est effectuée par des méthodes mathématiques combinatoires qui sont appliquées à des valeurs de mesure de différents capteurs de mesure de puissance (6) du réseau de distribution.

6. Procédé selon l'une des revendications précédentes, **caractérisé en ce que** la vérification de la plausibilité est effectuée par des méthodes de caractéristiques mathématiques qui reposent sur des valeurs extrêmes ou des pentes de valeurs de mesure de capteurs de mesure de puissance (6) du réseau de distribution.

7. Procédé selon l'une des revendications précédentes, **caractérisé en ce que** la vérification de la plausibilité est effectuée par une transformée de Fourier rapide de valeurs de mesure de courant de capteurs de mesure de puissance (6) du réseau de distribution et par comparaison du spectre basse fréquence des séries de valeurs de mesure.

8. Procédé selon l'une des revendications précédentes, **caractérisé en ce que** plusieurs procédés différents de vérification de la plausibilité sont utilisés et évalués au moyen d'algorithmes auto-apprentissants.

9. Procédé selon l'une des revendications précédentes, **caractérisé en ce que** le réseau de distribution ou, le cas échéant, l'autre réseau de distribution est respectivement un réseau basse tension.

10. Procédé selon l'une des revendications précédentes, **caractérisé en ce que** le capteur de mesure de puissance (6) comprend un convertisseur de courant.

11. Procédé selon la revendication 9 et 10, **caractérisé en ce que** le capteur de mesure de puissance (6) comprend additionnellement une prise de tension directe pour le réseau basse tension.

12. Produit de programme informatique qui comprend un programme et peut être chargé directement dans une mémoire d'une unité de calcul (3,4) d'un réseau de distribution, comprenant des moyens de programme pour exécuter toutes les étapes du procédé selon l'une des revendications 1 à 12 lorsque le programme est exécuté par l'unité de calcul (3,4).
